# EUROPEAN PATENT SPECIFICATION

(11) **EP 2 533 617 B1**
(45) Date of publication and mention of the grant of the patent: **13.12.2017**
(21) Application number: 11736603.9
(22) Date of filing: 10.01.2011
(51) Int. Cl.: H05K 1/11, H05K 1/14, H05K 3/22

(54) **PRINTED CIRCUIT BOARD WITH CHIP PACKAGE COMPONENT**
LEITERPLATTE MIT CHIPGEHÄUSE
CARTE DE CIRCUIT AVEC BOÎTIER DE PUCE

(30) Priority: 01.02.2010 CN 201010104540
(43) Date of publication of application: 12.12.2012
(73) Proprietor: Huawei Device Co., Ltd., Shenzhen, Guangdong 518129 (CN)
(72) Inventor: JIANG, Zhiwei, Shenzhen Guangdong 518129 (CN); CHEN, Xiaochen, Shenzhen Guangdong 518129 (CN); GUO, Zhipeng, Shenzhen Guangdong 518129 (CN)
(74) Representative: Gill Jennings & Every LLP
(86) International application number: PCT/CN2011/070120
(87) International publication number: WO 2011/091721

(56) References cited:
- WO-A1-00/19532
- CN-A- 101 005 732
- CN-A- 101 796 729
- US-A- 3 770 874
- US-A1- 2002 125 043
- US-A1- 2006 213 058
- US-B2- 6 469 393

## Description

### FIELD OF THE INVENTION

The present invention relates to the field of circuits, and in particular, to a printed circuit board assembly chip package component and a soldering component.

### BACKGROUND OF THE INVENTION

In current electronic products, the level of integration becomes higher and higher, so that the product cost of a terminal must be strictly controlled.

In order to reduce the cost effectively, a design scheme of a highly integrated module appears in the prior art, and the scheme can be applied to all types of user terminal products. Taking mobile phones for example, functions of hardware of most mobile phones are substantially the same. Some core components on a single board may be integrated in a larger module, and then the module is soldered on different printed circuit boards, PCB, Printed Circuit Board, so as to satisfy different demands.

The soldered modules in the prior art are generally packaged in two manners. One is adopting a land grid array, LGA, Land Grid Array, package manner, and the other is adopting a castle-type package manner.

However, in the prior art, the highly integrated module has many pins, and accordingly has a large number of soldering pads. After a chip package module is soldered on the PCB by adopting the soldering manner in the prior art, when some soldering pads need to be repaired because a phenomenon such as insufficient soldering and missing soldering occurs, the entire module needs to be taken down from the PCB board for re-soldering. However, the process of disassembling and assembling of the module may affect a chip on the module, and therefore, the chip packaging manner in the prior art does not facilitate repairing.

US6469393 discloses a semiconductor package and mount board, the semiconductor package and mount board comprises a semiconductor chip having input or output terminals, a relay board having package side lands having a defined surface area and side walls and being arranged on a principal plane thereof in association with said respective input or output terminals of said semiconductor chip, and a first solder resist layer mutually insulating said package side lands and having openings having a larger area than the surface area of said package side lands so that a gap exist between the first solder resist layer and said package side lands, a base member, board side lands having a defined surface area and side walls and being disposed on one principal plane of said base member in the same arrangement of said package side lands which are to be mounted thereon through a soldering layer which adheres only to the complementary package side lands and board side lands which complement each other when the relay board is mounted over the base member and the soldering layer extends to the side walls thereof, a second solder resist layer mutually insulating said board side lands and having openings having a larger area than the surface area of said board side lands so that a gap exists between the second solder resist layer and said board side lands wherein the gaps respectively between the first solder resist layer and the package side lands and the second solder resist layer and the board side lands have the same dimension and whereby each soldering layer between the complementary package and board side lands does not extend to said first and second solder resist layers; and wherein said complementary package side lands and said board side lands are equal to each other in shape and dimension so that the soldering layers between the complementary package and board side lands are substantially uniform in profile and the first and second solder resist layers are respectively provided between each pair of adjacent package and board side lands but do not overlap the adjacent package and board side lands.US20060213058, describes a circuit board for a surface-mount device to be mounted thereon. The surface-mount device includes a set of first pins and a set of second pins. The circuit board includes a substrate, a set of first conductors, a set of second conductors, and a hole. The hole is formed through the substrate and adjacent to the set of second conductors. The mounting of the surface-mount device is performed by the steps of: (a) disposing the surface-mount device on the substrate; (b) soldering the set of first pins on the set of first conductors and the set of second pins on the set of second conductors by reflowing; (c) checking whether each second pin is electrically-connected with the corresponding second conductor; and (d) re-soldering the second pin that is electrically-disconnected with the corresponding second conductor by a welder through the hole.

US3770874 discloses that a contact member 11a is bonded to a non-conductive substrate 1, and comprises at least two geometric areas 2 and 4 interconnected by a narrow bridge area 3, and relatively thick solder domes or hemisphere area 5 form on each of the areas 2 and 4 and a relatively thin solder 5a forms on bridge area 3; An electrical component 6, such as a semiconductor, etc..., having a contact area 7 is positioned in working relation with area 4 of contact member 11a, and localized heat is applied to one of the solder domes 5 so that a bond forms between the contact area 7 and the solder.

### SUMMARY OF THE INVENTION

Embodiments of the present invention provide a printed circuit board with a chip package component mounted thereon (also called a Printed Circuit Board Assembly or PCBA chip package module) which can facilitate repairing of a PCBA chip package module.

The printed circuit board with a chip package component mounted thereon provided in an embodiment of the present invention includes: the chip package component includes a module board and the printed circuit board includes an interface board. A plurality of first soldering pads is set on the bottom of the module board. A plurality of second soldering pads (4021) is set on the interface board. The interface board comprises an opening located under the chip package component. Each first soldering pad comprises a first soldering area, a second soldering area, and a connection bridge that connects the first soldering area and the second soldering area, the connection bridge being narrower than the first and the second soldering area. Each second soldering pad comprises a top area on the top of the interface board, a bottom area on the bottom of the interface board and a side area on a sidewall of the opening of the interface board, the side area of the second soldering pad connecting the top area and the bottom area of the second soldering pad. Each first soldering area of the first soldering pads corresponds to the top area of one of the second soldering pads, wherein the second soldering area of the first soldering pads is located above the opening in the interface board.

The soldering component provided in an embodiment of the present invention includes: a first soldering pad and a second soldering pad. The second soldering pad is of a castle-type structure. The first soldering pad includes a first soldering area, a second soldering area, and a connection bridge that connects the first soldering area and the second soldering area. The first soldering area corresponds to a top surface of the second soldering pad, and when the first soldering area is soldered to second soldering pad, the second soldering area is located outside the second soldering pad.

From the foregoing technical solutions, it can be seen that the embodiments of the present invention have the following advantages.

In the embodiments of the present invention, the first soldering pad on the bottom of the module board is divided into two soldering areas, where the first soldering area is soldered to the top surface of the second soldering pad on top of the interface board, and the second soldering area is located outside the second soldering pad, and therefore, observation of a soldering situation between the module board and the interface board is facilitated.

When a phenomenon such as insufficient soldering and missing soldering occurs between the module board and the interface board, repair soldering may be directly performed on a soldering pad where the problem occurs. That is, the second soldering area of the first soldering pad and a side surface of the second soldering pad are connected by solder. Therefore, the repairing of the PCBA chip package module can be implemented without disassembling the entire module board, which thereby facilitates the repairing of the PCBA chip package module.

### BRIEF DESCRIPTION OF THE DRAWINGS

To illustrate technical solutions in embodiments of the present invention more clearly, accompanying drawings to be used for describing the embodiments or the prior art are introduced briefly in the following.
FIG. 1 is a top view of a soldering component,
FIG. 2 is a side view of a soldering component;
FIG. 3 is a schematic diagram of a soldering component and
FIG. 4 is a schematic diagram of a PCBA chip package component according to an embodiment of the present invention.

### DETAILED DESCRIPTION OF THE EMBODIMENTS

The embodiments of the present invention provide a printed circuit board with a chip package component mounted thereon which can facilitate repairing of a PCBA chip package module.

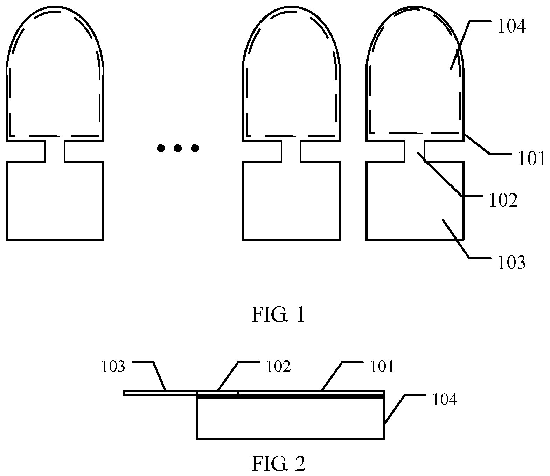

First, a soldering component is introduced. Referring to FIG. 1, the soldering component includes:
a first soldering pad and a second soldering pad 104, where the second soldering pad 104 is of a castle-type structure;

The first soldering pad includes a first soldering area 101, a second soldering area 103, and a connection bridge 102 that connects the first soldering area 101 and the second soldering area 103.

The first soldering area 101 corresponds to a top surface of the second soldering pad 104, and when the first soldering area 101 is soldered to the second soldering pad 104, the second soldering area 103 is located outside the second soldering pad 104.

It should be noted that, the size and shape of the second soldering pad 104 may be substantially the same as those of the first soldering area 101 of the first soldering pad. The first soldering area 101 of the first soldering pad may be a semi-ellipse or a rectangle, or be in other shapes, which is not specifically limited herein.

In order to facilitate understanding, the soldering component is described in a direction of a section view in the following. Referring to FIG. 2, the first soldering area 101 of the first soldering pad corresponds to the top of the second soldering pad 104, and the shapes and areas are similar. However, when the second soldering pad 104 is soldered to the first soldering area 101 of the first soldering pad, the second soldering area 103 of the first soldering pad is located outside the second soldering pad 104, that is, is exposed beyond the second soldering pad 104 and not covered.

When a phenomenon such as insufficient soldering and missing soldering occurs between the first soldering area 101 of the first soldering pad and the second soldering pad 104, the second soldering area 103 of the first soldering pad and a side surface of the second soldering pad 104 may be connected by solder. The connection bridge 102 exists between the first soldering area 101 and the second soldering area 103 of the first soldering pad, so soldering of the first soldering pad and the second soldering pad 104 may also be completed by directly performing repair soldering on the second soldering area 103 and the side surface of the second soldering pad 104, and therefore, repair soldering can be performed conveniently. That is, the second soldering area 103 of the first soldering pad and the side surface of the second soldering pad 104 are connected by the solder. Therefore, the repairing of the PCBA chip package module can be implemented without disassembling the entire module board, which thereby facilitates the repairing of the PCBA chip package module. When the first soldering area 101 of the first soldering pad is of a semi-elliptic structure, its outer edge is smooth, it is not likely to cause accumulation of the solder tin, and therefore, solder bridge between soldering pads is effectively avoided during soldering.

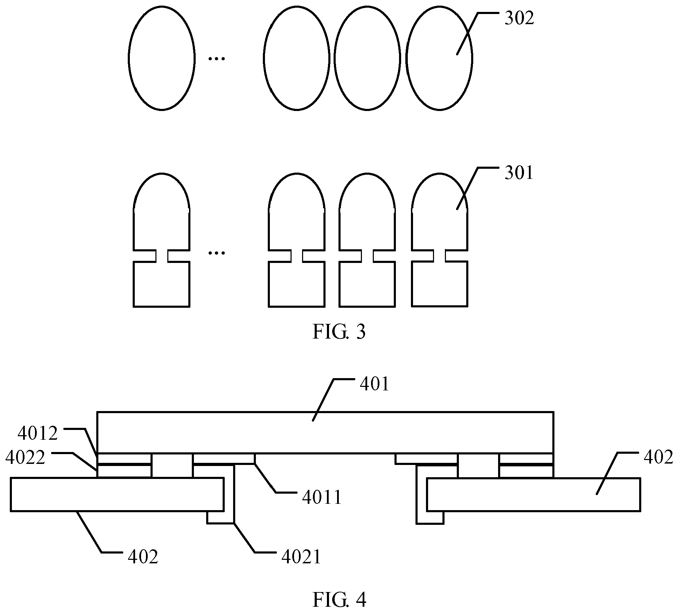

The soldering component described in FIG. 1 and FIG. 2 is single ring soldering. In practical applications, in order to increase the level of integration, more pins may be set. Accordingly, the soldering component may also provide more rings of soldering pads, which may specifically be shown in FIG. 3. A soldering pad 301 may be used as an inner ring soldering pad, and a soldering pad 302 may be used as an outer ring soldering pad. The soldering pad 302 may be configured to be of an elliptic structure, so as to improve the soldering effect, and avoid the solder bridge between soldering pads as much as possible.

The foregoing illustration is provided with two rings of soldering pads being an example. In practical applications, more rings of soldering pad may exist, which is not specifically limited herein.

In practical applications, different soldering pads of the soldering component may be located on different circuit boards. A PCBA chip package component to which the foregoing soldering component is applied is illustrated with reference to a specific example in the following. Referring to FIG. 4, the PCBA chip package component in the embodiments of the present invention includes:
a module board 401 and an interface board 402.

A first soldering pad 4011 is set on the bottom of the module board 401, a second soldering pad 4021 is set on the interface board, and the second soldering pad 4021 is of a castle-type semi-hole structure.

It should be noted that, the castle-type semi-hole structure of the second soldering pad 4021 is the same as a castle-type semi-hole structure in the prior art, which is not described again herein.

The first soldering pad 4011 includes a first soldering area, a second soldering area, and a connection bridge that connects the first soldering area and the second soldering area, and the specific structure may be as the content shown in FIG. 1.

The first soldering area corresponds to a top surface of the second soldering pad 4021, and when the first soldering area is soldered to the second soldering pad 4021, the second soldering area is located outside the second soldering pad 4021 and the second soldering area may be connected to a side surface of the second soldering pad 4021 by solder.

In this embodiment, the first soldering pad 4011 may be an inner ring soldering pad of the module board 401, that is, the module board 401 may also include an outer ring soldering pad, that is, a third soldering pad 4012. Accordingly, a fourth soldering pad 4022 corresponding to the third soldering pad 4012 may also be set on the interface board 402.

In this embodiment, the first soldering area of the first soldering pad 4011 may be a semi-ellipse, and the third soldering pad 4012 and the fourth soldering pad 4022 may be ellipses. The outer edge of an ellipse is smooth, it is not likely to cause accumulation of the solder, and therefore, solder bridge between soldering pads is effectively avoided during soldering.

The foregoing illustration is provided with only two rings of soldering pads being an example. In practical applications, more rings of soldering pads may exist, which is not specifically limited herein.

The third soldering pad 4012 and the fourth soldering pad 4022 in the embodiments of the present invention may be castle-type soldering pads, or LGA soldering pads in practical applications, which is not specifically limited herein.

When reflow soldering is performed on the module board 401 and the interface board 402, the module board 401 may have a certain level of warping, which may lower the soldering quality. However, the castle-type soldering pad is an embedded pad. When the third soldering pad 4012 and the fourth soldering pad 4022 are castle-type soldering pads, the position of the module board 401 and that of the interface board 402 may be fixed relative to each other, so that the warping is not likely to occur, and therefore the soldering quality may be improved.

In another aspect, the larger an area of the module board 401 is, the higher the level of warping is during the reflow soldering of the module board 401. Two rings of castle-type soldering pad may effectively avoid the warping, so the area of the module board 401 may be increased so as to increase the level of integration.

In this embodiment, when the reflow soldering is performed on the module board 401 and the interface board 402, a pressing block may be used on the module board 401 to further reduce the warping during the soldering, so as to further improve the soldering quality.

In this embodiment, the first soldering pad on the bottom of the module board is divided into two soldering areas, where the first soldering area is soldered to the top surface of the second soldering pad on top of the interface board, and the second soldering area is located outside the second soldering pad, and therefore, observation of a soldering situation between the module board and the interface board is facilitated.

When a phenomenon such as insufficient soldering and missing soldering occurs between the module board and the interface board, repair soldering may be directly performed on the soldering pads where the problem occurs, that is, the second soldering area of the first soldering pad and the side surface of the second soldering pad are connected by the solder. Therefore, the repairing of the PCBA chip package module can be implemented without disassembling the entire module board, which thereby, facilitates the repairing of the PCBA chip package module.

In this embodiment, the third soldering pad 4012 may be of an elliptic structure, and the first soldering area of the first soldering pad 4011 may be of a semi-elliptic structure. The outer edge of an ellipse is smooth, so that it is not likely to cause accumulation of the solder, and therefore, solder bridge between soldering pads may be effectively avoided during soldering.

According to the ideas of the embodiments of the present invention, persons of ordinary skill in the art can make variations to the present invention within the scope of the claims.

## Claims

1. A printed circuit board with a chip package component mounted thereon, wherein the chip package component comprises a module board (401) and the printed circuit board comprises an interface board (402); wherein a plurality of first soldering pads (4011) is set on the bottom of the module board (401), a plurality of second soldering pads (4021) is set on the interface board (402), **characterized in that**:
the interface board (402) comprises an opening located under the chip package component;
each first soldering pad (4011) comprises a first soldering area, a second soldering area, and a connection bridge that connects the first soldering area and the second soldering area, the connection bridge being narrower than the first and the second soldering area; and
each second soldering pad (4021) comprises a top area on the top of the interface board (402), a bottom area on the bottom of the interface board (402) and a side area on a sidewall of the opening of the interface board (402), the side area of the second soldering pad (4021) connecting the top area and the bottom area of the second soldering pad (4021);
each first soldering area of the first soldering pads (4011) corresponds to the top area of one of the second soldering pads (4021), wherein the second soldering area of the first soldering pads (4011) is located above the opening in the interface board (402).

2. The printed circuit board with a chip package component according to claim 1, wherein
the first soldering pad (4011) is an inner ring soldering pad, a third soldering pad (4012) is also set on the bottom of the module board (401), and the third soldering pad (4012) is an outer ring soldering pad.

3. The printed circuit board with a chip package component according to any one of claims 1 to 2, wherein the first soldering area of the first soldering pad (4011) is a semi-ellipse.

4. The printed circuit board with a chip package component according to claim 2, wherein the third soldering pad (4012) is an ellipse.

5. The printed circuit board with a chip package component according to claim 2, wherein a fourth soldering pad (4022) corresponding to the third soldering pad (4012) is set on top of the interface board (402).

## Patentansprüche

1. Leiterplatte mit einer darauf montierten Chipgehäusekomponente, wobei die Chipgehäusekomponente eine Modulplatine (401) umfasst und die Leiterplatte eine Schnittstellenplatine (402) umfasst; wobei mehrere erste Lötpads (4011) an der Unterseite der Modulplatine (401) angeordnet sind, wobei mehrere zweite Lötpads (4021) auf der Schnittstellenplatine (402) angeordnet sind, **dadurch gekennzeichnet, dass**
die Schnittstellenplatine (402) eine Öffnung aufweist, die sich unter der Chipgehäusekomponente befindet;
jedes erste Lötpad (4011) einen ersten Lötbereich, einen zweiten Lötbereich und eine Verbindungsbrücke, die den ersten Lötbereich und den zweiten Lötbereich verbindet, umfasst, wobei die Verbindungsbrücke schmaler als der erste und zweite Lötbereich ist; und
jedes zweite Lötpad (4021) einen oberen Bereich auf der Oberseite der Schnittstellenplatine (402), einen unteren Bereich auf der Unterseite der Schnittstellenplatine (402) und einen seitlichen Bereich auf einer Seitenwand der Öffnung der Schnittstellenplatine (402) umfasst, wobei der seitliche Bereich des zweiten Lötpads (4021) den oberen Bereich und den unteren Bereich des zweiten Lötpads (4021) verbindet;
jeder erste Lötbereich der ersten Lötpads (4011) dem oberen Bereich von einem der zweiten Lötpads (4021) entspricht, wobei sich der zweite Lötbereich der ersten Lötpads (4011) oberhalb der Öffnung in der Schnittstellenplatine (402) befindet.

2. Leiterplatte mit einer Chipgehäusekomponente nach Anspruch 1, wobei das erste Lötpad (4011) ein Innenringlötpad ist, ein drittes Lötpad (4012) auch auf der Unterseite der Modulplatine (401) angeordnet ist und das dritte Lötpad (4012) ein Außenringlötpad ist.

3. Leiterplatte mit einer Chipgehäusekomponente nach einem der Ansprüche 1 bis 2, wobei der erste Lötbereich des ersten Lötpads (4011) eine Halbellipse ist.

4. Leiterplatte mit einer Chipgehäusekomponente nach Anspruch 2, wobei das dritte Lötpad (4012) eine Ellipse ist.

5. Leiterplatte mit einer Chipgehäusekomponente nach Anspruch 2, wobei ein viertes Lötpad (4022), das dem dritten Lötpad (4012) entspricht, oben auf der Schnittstellenplatine (402) angeordnet ist.

## Revendications

1. Carte de circuit imprimé sur laquelle est monté un composant de boîtier pavé, dans laquelle le composant de boîtier pavé comprend une carte de module (401) et la carte de circuit imprimé comprend une carte d'interface (402) ; dans laquelle une pluralité de premières plages de brasure (4011) est établie sur le fond de la carte de module (401), une pluralité de deuxièmes plages de brasure (4021) est établie sur la carte d'interface (402), **caractérisée en ce que** :
la carte d'interface (402) comprend une ouverture située sous le composant de boîtier pavé ;
chaque première plage de brasure (4011) comprend une première zone de brasure, une seconde zone de brasure et un pont de connexion qui connecte la première zone de brasure et la seconde zone de brasure, le pont de connexion étant plus étroit que la première et la seconde zone de brasure ; et
chaque deuxième plage de brasure (4021) comprend une zone de dessus sur le dessus de la carte d'interface (402), une zone de fond sur le fond de la carte d'interface (402) et une zone de côté sur une paroi latérale de l'ouverture de la carte d'interface (402), la zone de côté de la deuxième plage de brasure (4021) connectant la zone de dessus et la zone de fond de la deuxième plage de brasure (4021) ;
chaque première zone de brasure des premières plages de brasure (4011) correspond à la zone de dessus de l'une des deuxièmes plages de brasure (4021), dans laquelle la seconde zone de brasure des premières plages de brasure (4011) est située au-dessus de l'ouverture dans la carte d'interface (402).

2. Carte de circuit imprimé avec un composant de boîtier pavé selon la revendication 1, dans laquelle
la première plage de brasure (4011) est une plage de brasure d'anneau interne, une troisième plage de brasure (4012) est également établie sur le fond de la carte de module (401), et la troisième plage de brasure (4012) est une plage de brasure d'anneau externe.

3. Carte de circuit imprimé avec un composant de boîtier pavé selon l'une quelconque des revendications 1 et 2, dans laquelle la première zone de brasure de la première plage de brasure (4011) est une demi-ellipse.

4. Carte de circuit imprimé avec un composant de boîtier pavé selon la revendication 2, dans laquelle la troisième plage de brasure (4012) est une ellipse.

5. Carte de circuit imprimé avec un composant de boîtier pavé selon la revendication 2, dans laquelle une quatrième plage de brasure (4022) correspondant à la troisième plage de brasure (4012) est établie par-dessus la carte d'interface (402).
